(19) Europäisches Patentamt
European Patent Office
Office européen des brevets

(11) **EP 1 855 514 A1**

(12) **EUROPEAN PATENT APPLICATION**

(43) Date of publication:
**14.11.2007 Bulletin 2007/46**

(51) Int Cl.:
*H05K 3/12* (2006.01)      *H05K 3/46* (2006.01)
*H01Q 1/24* (2006.01)      *H01Q 1/40* (2006.01)

(21) Application number: **06445022.4**

(22) Date of filing: **10.05.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **AMC Centurion AB**
**184 25 Akersberga (SE)**

(72) Inventor: **Palin, Ulf**
**184 97 Ljusterö (SE)**

(74) Representative: **Estreen, Lars J.F. et al**
**Kransell & Wennborg KB**
**P.O. Box 27834**
**115 93 Stockholm (SE)**

(54) **Production of antenna devices**

(57)    The present invention relates to a method of producing an antenna device for a portable radio communication device. The method comprises the following steps: non-contact printing of a first layer of conductive ink (2) on a dielectric substrate (1); non-contact printing of a first layer of dielectric polymer (3) on said first layer of conductive ink (2); non-contact printing of a second layer of conductive ink (4) on said first layer of dielectric polymer (3); and non-contact printing of a second layer of dielectric polymer (5) on said second layer of conductive ink (4).

**FIG. 1**

## Description

## FIELD OF INVENTION

The present invention relates generally to antenna devices for portable radio communication devices and particularly to a method of producing an antenna device for a portable radio communication device, to an antenna device produced according to the method, and to a portable radio communication device comprising the antenna device.

## BACKGROUND OF THE INVENTION

As portable radio communication devices such as mobile phones, portable computers, and other personal communication systems become smaller, the electronic components contained within the devices, such as internally mounted antennas, will tend to be smaller also. Such internally mounted antennas generally have very limited space.

Mobile communication devices are also subject to cost reduction demands as well as increasing adaptation for large-scale manufacturing. For that reason parts included in a mobile phone are preferably designed to ensure low production and assembling costs.

In order to minimize size requirements and permit low cost production the internally mounted antennas may typically be provided as printed antennas. Two techniques frequently employed in this respect are screen-printing and tampon printing. While such techniques are simple and cost effective they are not very flexible since the antenna patterns to be produced have to be determined at an early stage in the production process. Further, they are difficult to use for the production of antenna patterns onto curved surfaces, particularly three dimensionally curved surfaces, if at all possible.

Still further, it is highly desirable that such printed antennas be mass-produced or produced in such a way that costs are reduced and efficiency is increased. It is also desirable that the method of mass-producing the printed antennas maintains a high level of flexibility, uniformity and quality.

## SUMMARY OF THE INVENTION

An object of the present invention is to provide a method of producing an antenna device for a portable radio communication device, which method is flexible and provides for a compact antenna device.

A further object of the present invention is to provide a compact antenna device.

Another object of the present invention is to provide a portable radio communication device comprising a compact antenna device.

These objects, among others, are according to the present invention attained by a method, antenna device and a portable radio communication device, respectively as defined in the appended claims.

By non-contact printing of a multi-layer antenna a compact antenna is produced, which further easily can be provided on complex surfaces. Manufacturing and assembly of such an antenna device can be made to a low cost and also at a high level of flexibility.

Further features and advantages of the present invention will be evident from the following description.

## BRIEF DESCRIPTION OF DRAWINGS

The present invention will become more fully understood from the detailed description of embodiments given below and the accompanying drawings, which are given by way of illustration only, and thus, are not limitative to the present invention, wherein:

  Fig. 1 illustrates a first embodiment of an antenna device produced by a method according to the present invention;

  Fig. 2 is an exploded view of Fig. 1;

  Fig. 3 illustrates a second embodiment of an antenna device produced by a method according to the present invention;

  Fig. 4 is an exploded view of Fig. 3;

  Fig. 5 illustrates a radiating element on top of power supply conductors; and

  Fig. 6 illustrates a first radiating element on top of a second radiating element.

## DETAILED DESCRIPTION OF PREFERRED EMBODIMENTS

In the following description, for purpose of explanation and not limitation, specific details are set forth, such as particular techniques and applications in order to provide a thorough understanding of the present invention. However, it will be apparent for a person skilled in the art that the present invention may be practiced in other embodiments that depart from these specific details. In other instances, detailed description of well-known methods and apparatuses are omitted so as not to obscure the description of the present invention with unnecessary details.

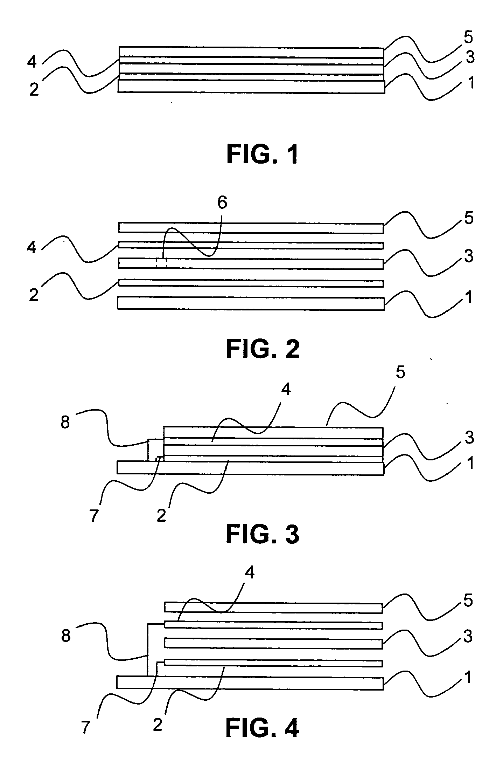

A first embodiment of the present invention will now be described with reference to Figs. 1 and 2.

A multi-layered antenna device for a portable radio communication device, such as a cellular phone or similar device, comprising a first layer of conductive ink 2 on a dielectric substrate 1; a first layer of dielectric polymer 3 on the first layer of conductive ink 2; a second layer of conductive ink 4 on the first layer of dielectric polymer 3; and a second layer of dielectric polymer 5 on the second layer of conductive ink 4, is produced by the following method.

The dielectric substrate 1 is first provided as a base for the multi-layered antenna device, which dielectric substrate 1 e.g. can be an injection molded part or a flex film, such as a PET (Polyethylene Terephthalate) or Kapton (PEI) film. The dielectric substrate 1 can for instance form a part of the inside of a back cover of the portable radio communication device. The inside of the back cover typically has a three-dimensional curvature, which is particularly suited for a non-contact printing method. To provide a good printing for particularly three-dimensional curvature the printing head and the multi-layered antenna are movable relative each other in a three-dimensional space. When a PET film or similar is used as base for the multi-layered antenna device it is preferably mounted to a carrier to give the multi-layered antenna device adequate support during printing.

Secondly a first layer of conductive ink 2 is printed by a non-contact printing method, such as ink jet printing or similar, on the dielectric substrate 1. Thirdly a first layer of dielectric polymer 3 is printed by a non-contact printing method, such as ink jet printing or similar, on the first layer of conductive ink 2. Fourthly a second layer of conductive ink 4 is printed by a non-contact printing method, such as ink jet printing or similar, on the first layer of dielectric polymer 3. Lastly a second layer of dielectric polymer 5 is printed by a non-contact printing method, such as ink jet printing or similar, on the second layer of conductive ink 4. The second layer of dielectric polymer is primarily for protection of the multi-layered antenna device. The first and second layers of conductive ink form conductive patterns for e.g. radiating elements, power supply connectors, matching components and electric components of the multi-layered antenna device.

Ink jet printing can e.g. be performed by a drop on demand or by a continuous printing technique. An alternative non-contact printing method is a spray technique, but it is particularly suitable for printing of radiating element patterns.

The dielectric polymer can e.g. be comprised of acrylic, polyester, or polyurethane. The dielectric polymer can further be modified by use of a ceramic filler or a magnetic material, to modify the dielectric constant of the dielectric layer.

Although only two conductive layers have been described it is possible to add a plurality of additional conductive/dielectric layers to the multi-layer antenna device.

When the layers of dielectric polymer are printed, particularly a layer of dielectric polymer between two conductive layers, the pattern of the printed dielectric polymer can be selected to omit portions of the layer, which will lead to the formation of via-holes 6 between two adjacent layers of conductive ink if the next layer of conductive ink is printed over the omitted portions. Via-holes can e.g. be used to contact a radiating element with ground and/or RF feed, or to provide matching by design of the conductive pattern.

Solidification of the conductive ink and/or the dielectric polymer may be speeded up by means of heating the conductive ink or the dielectric polymer, respectively, during printing onto the antenna device; or by means of blowing a gas, particularly dry air, over the printed conductive ink or dielectric polymer, respectively. By heating a conductive layer to approximately 150-400°, preferably to approximately 250-350°, and more preferably to approximately 300° most of the organic material of the conductive ink is burned away, and a very good conductive property of the conductive pattern is achieved. Alternatively, the conductive property of the conductive patterns can be improved by applying a pressure to the conductive ink, which will put the conductive particles of the conductive ink closed to each other. A typical conductive ink comprises e.g. about 80-85% Ag, or other conductive substances, and the rest is organic material which not has a good conductive property. By heating the conductive layer to approximately 300° most of the organic material of the conductive ink will be burned away and the conductive layer will comprise about 95-100% Ag.

The conductive property of the antenna device can further be improved by metallization of the conductive patterns. Metallization can e.g. be performed by electrolytic plating or electroless plating, which however is more expensive than electrolytic plating, or a combination of firstly performing electroless plating as a basis for secondly performing electrolytic plating onto the electroless plating.

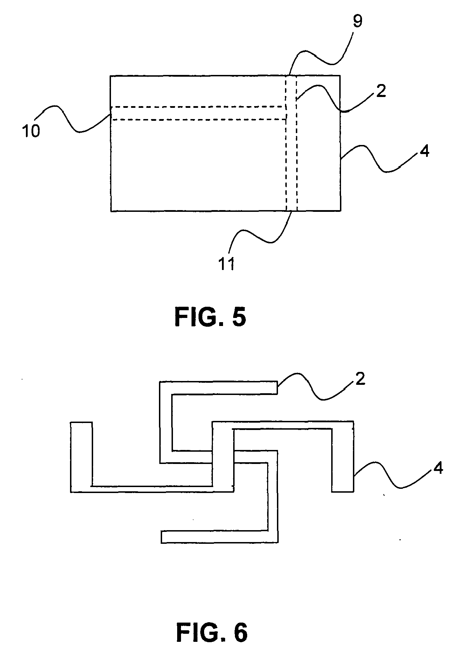

One of the first 2 and second 4 conductive layers preferably contains a radiating element (schematically shown a rectangular element) and the other contains a power supply connector, which is illustrated in Fig. 5. A first end 9 of the power supply connector can e.g. be connected to a power switch of the portable radio communication device, a second end 10 of the power supply connector can e.g. be connected to a volume control, and a third end 11 can e.g. be connected to a control circuit of the portable radio communication device. The total area taken up by the radiating element and the power supply connector will by this solution very little, since the volume of the multi-layered antenna device is utilized.

Further, it is possible integrate electrical circuits, such as capacitors, inductances, resistors, filters and matching circuits, into the multi-layered antenna device by use of the conductive patterns.

A capacitance can be calculated from the equation:

$$C = \varepsilon_0 \varepsilon_r \frac{A}{d},$$

where C is the capacitance in farads, F, $\varepsilon_0$ is the permit-

tivity of free space, measured in farads per meter, $\varepsilon_r$ is the dielectric constant or relative permittivity of the insulator used, A is the area of each plane electrode, measured in square meters, and d is the separation between the electrodes, measured in meters. For $\varepsilon_r$ = 3. 0, A = 1 mm$^2$, and d = 5 $\mu$m C = 5 . 3 pF.

A spiral inductor (wire) could also be integrated as an inductor. The inductance can be calculated from the equation:

$$L = \frac{(NR)^2}{8R+11W} ,$$

where L is the inductance in micro Henry, $\mu$H, N is the number of turns of the spiral, R is the radius of the spiral, W is the distance between the outermost and innermost turns. For N = 5, R = 1 mm, W = 0.5 mm L = 1.85 nH. Alternatively 1 mm of microstrip equals to about 1 nH inductance.

By positioning e.g. two meander antenna elements in two different conductive layers, 2 and 4, and across each other they can be positioned very closed to each other, but with very little interference, which is illustrated in Fig. 6.

The printing of the conductive and dielectric layers are preferably performed with the same non-contact printing method, and further with the same printing apparatus, to provide a cost effective production. Since the conductive ink and the dielectric polymer have different properties the printing apparatus preferably has a first nozzle for printing of the conductive ink and a second nozzle for printing of the dielectric polymer.

A second embodiment of the present invention will next be described with reference to Figs. 3 and 4. This second embodiment is identical with the first embodiment described above apart from the following.

Instead of formation of via-holes for connection between different conductive layers conductive ink is printed on the side of the antenna device to form conductors 7 and 8. These conductors can also connect two conductive layers directly to each other.

It is further possible to combine the first and second embodiment of the present invention to provide the multi-layered antenna device with both via-holes and conductors printed on the side thereof.

It will be obvious that the present invention may be varied in a plurality of ways. Such variations are not to be regarded as departure from the scope of the present invention as defined by the appended claims. All such variations as would be obvious for a person skilled in the art are intended to be included within the scope of the present invention as defined by the appended claims.

**Claims**

1. A method of producing an antenna device for a portable radio communication device, said method being **characterized by** the steps of:

   - non-contact printing of a first layer of conductive ink (2) on a dielectric substrate (1);
   - non-contact printing of a first layer of dielectric polymer (3) on said first layer of conductive ink (2);
   - non-contact printing of a second layer of conductive ink (4) on said first layer of dielectric polymer (3); and
   - non-contact printing of a second layer of dielectric polymer (5) on said second layer of conductive ink (4).

2. The method as claimed in claim 1, wherein said non-contact printing is provided by ink jet printing.

3. The method as claimed in claim 1 or 2, comprising a step of curing said conductive ink at approximately 150-400°, preferably at approximately 250-350°, more preferably at approximately 300°.

4. The method as claimed in any of claims 1-3, wherein said dielectric substrate constitute part of an outer casing of said portable radio communication device when attached thereto.

5. The method as claimed in any of claims 1-3, wherein said dielectric substrate is a flex film.

6. The method as claimed in any of claims 1-5, wherein said dielectric substrate comprises a three-dimensional curvature.

7. The method as claimed in any of claims 1-6, comprising a step of metalizing at least one of said first and second layer of conductive ink.

8. The method as claimed in any of claims 1-7, wherein at least one of said first and second layer of conductive ink comprise a power supply conductor for a part beyond the antenna device.

9. The method as claimed in any of claims 1-8, wherein at least one of said first and second layer of conductive ink comprises a radiating element.

10. The method as claimed in any of claims 1-7, wherein at least one of said first and second layer of conductive ink comprise a power supply conductor for a part beyond the antenna device, and at least one of said first and second layer of conducive ink comprise a radiating element, wherein said power supply conductor and said radiating element overlap each other.

11. The method as claimed in any of claims 1-10, wherein at least said first dielectric layer comprises a via-hole.

12. The method as claimed in any of claims 1-11, wherein all steps of said non-contact printing are performed by one printing apparatus.

13. The method as claimed in claim 12, wherein said non-contact printing of conductive ink is performed through a first nozzle of said one printing apparatus and said non-contact printing of dielectric polymer is performed through a second nozzle of said one printing apparatus.

14. An antenna device for use in a portable radio communication device, **characterized in that** said antenna device is produced according to the method as claimed in any of claims 1-13.

15. A portable radio communication device comprising an antenna device, **characterized in that** said portable radio communication device comprises, the antenna device as claimed in claim 14.

FIG. 1

FIG. 2

FIG. 3

FIG. 4

**FIG. 5**

**FIG. 6**

**European Patent Office**

**EUROPEAN SEARCH REPORT**

Application Number

EP 06 44 5022

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | GB 2 380 068 A (* JAYBEE GRAPHICS; * SILCON TECHNOLOGIES) 26 March 2003 (2003-03-26) * the whole document * ----- | 1-15 | INV. H05K3/12 H05K3/46 H01Q1/24 H01Q1/40 |
| Y | US 2004/060162 A1 (MOREN STEFAN) 1 April 2004 (2004-04-01) * the whole document * ----- | 1-15 | |
| A | WO 00/77854 A (GEMPLUS; MORGAVI, PAUL; BRUNET, OLIVIER; PATRICE, PHILIPPE) 21 December 2000 (2000-12-21) * the whole document * ----- | 1-15 | |
| | | | TECHNICAL FIELDS SEARCHED (IPC) |
| | | | H05K H01Q |

The present search report has been drawn up for all claims

| Place of search | Date of completion of the search | Examiner |
|---|---|---|
| The Hague | 12 July 2006 | Moumen, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 06 44 5022

This annex lists the patent family members relating to the patent documents cited in the above-mentioned European search report.
The members are as contained in the European Patent Office EDP file on
The European Patent Office is in no way liable for these particulars which are merely given for the purpose of information.

12-07-2006

| Patent document cited in search report | | Publication date | Patent family member(s) | | Publication date |
|---|---|---|---|---|---|
| GB 2380068 | A | 26-03-2003 | NONE | | |
| US 2004060162 | A1 | 01-04-2004 | CN | 1484935 A | 24-03-2004 |
| | | | EP | 1346616 A1 | 24-09-2003 |
| | | | SE | 519904 C2 | 22-04-2003 |
| | | | SE | 0004909 A | 09-11-2001 |
| | | | WO | 02054841 A1 | 11-07-2002 |
| WO 0077854 | A | 21-12-2000 | AU | 5412200 A | 02-01-2001 |
| | | | FR | 2795234 A1 | 22-12-2000 |

EPO FORM P0459

For more details about this annex : see Official Journal of the European Patent Office, No. 12/82